# EUROPEAN PATENT APPLICATION

(11) **EP 3 693 796 A1**
(43) Date of publication of application: **12.08.2020**
(21) Application number: 19156092.9
(22) Date of filing: 08.02.2019
(51) Int. Cl.: G03F 7/20, B08B 7/00, G02B 26/10, G02B 27/00, B23K 26/0622

(54) **LITHOGRAPHIC APPARATUS AND METHOD OF CLEANING**

(71) Applicant: ASML Netherlands B.V., 5500 AH Veldhoven (NL)
(72) Inventor: VAN DE KERKHOF, Marcus Adrianus, 5500 AH Veldhoven (NL); VORONINA, Victoria, 5500 AH Veldhoven (NL); OSORIO OLIVEROS, Edgar Alberto, 5500 AH Veldhoven (NL); VAN DER HORST, Ruud Martinus, 5500 AH Veldhoven (NL)
(74) Representative: Slenders, Petrus Johannes Waltherus

(57) **Abstract**

A lithographic apparatus comprising: a component (100) subject to contamination (101); and a cleaning system (200), the cleaning system comprising a laser radiation source (201) configured to emit pulses of radiation (202); a beam delivery system (204,205) configured to direct the radiation to a point of incidence (P) on the component; and an actuator (206) for controlling the position of the point of incidence with respect to the component.

## Description

### FIELD

The present invention relates to lithographic apparatus and to methods of cleaning components of lithographic apparatus. The present invention has particular, but not exclusive, use in connection with EUV lithographic apparatus and EUV lithographic tools.

### BACKGROUND

A lithographic apparatus is a machine constructed to apply a desired pattern onto a substrate. A lithographic apparatus can be used, for example, in the manufacture of integrated circuits (ICs). A lithographic apparatus may for example project a pattern from a patterning device (e.g., a mask) onto a layer of radiation-sensitive material (resist) provided on a substrate.

The wavelength of radiation used by a lithographic apparatus to project a pattern onto a substrate determines the minimum size of features that can be formed on that substrate. A lithographic apparatus that uses EUV radiation, that is electromagnetic radiation having a wavelength within the range 4-20 nm, may be used to form smaller features on a substrate than a lithographic apparatus using DUV radiation (for example with a wavelength of 193 nm).

The beam path, including the mask and substrate, in a lithographic apparatus using EUV is kept at a very low pressure in order to minimise the absorption of the EUV radiation. Such a lithographic apparatus is often referred to as being "in vacuum" but there may well be a low pressure of hydrogen in order to control contamination, especially of Sn fuel deriving from a laser-produced plasma (LPP) source. In spite of the low pressure environment in an EUV lithographic apparatus, surfaces therein can become contaminated, e.g. with carbon layers. Cleaning contaminated surfaces of an EUV lithographic apparatus is difficult and time consuming, leading to excessive downtime, during which the EUV lithographic apparatus cannot be used.

To avoid having to open up the vacuum chamber of an EUV lithographic apparatus for cleaning, hydrogen radical generators are used to remove carbon deposits. A hydrogen radical generator comprises a heated tungsten filament which disassociates H₂ molecules into atomic hydrogen. The atomic hydrogen atoms react with carbon deposits to form CH₄ (methane) which is gaseous and so can be pumped away. However, removing carbon deposits by this method is slow, in particular due to the time taken for the component that has been cleaned to cool down, and the heat load may damage the object being cleaned.

### SUMMARY

It is desirable to provide a way of cleaning surfaces in a lithographic apparatus that reduces downtime and damage to objects being cleaned.

According to a first aspect of the invention there is provided a lithographic apparatus comprising: a component subject to contamination; and a cleaning system, the cleaning system comprising: a laser radiation source configured to emit pulses of radiation; a beam delivery system configured to direct the radiation to a point of incidence on the component; and an actuator for controlling the position of the point of incidence with respect to the component.

According to a second aspect of the invention there is provided a method of cleaning a component in a lithographic apparatus, the method comprising: directing pulsed laser radiation at a point of incidence on the component; and moving the point of incidence with respect to the component.

Features of different aspects of the invention may be combined with features of other aspects of the invention.

### BRIEF DESCRIPTION OF THE DRAWINGS

Embodiments of the invention will now be described, by way of example only, with reference to the accompanying schematic drawings, in which:
Figure 1 is a schematic illustration of a lithographic system comprising a lithographic apparatus and a radiation source;
Figure 2 is a schematic illustration of a cleaning system in a lithographic apparatus according to a first embodiment of the invention; and
Figure 3 is a schematic illustration of a cleaning system in a lithographic apparatus according to a second embodiment of the invention.

### DETAILED DESCRIPTION

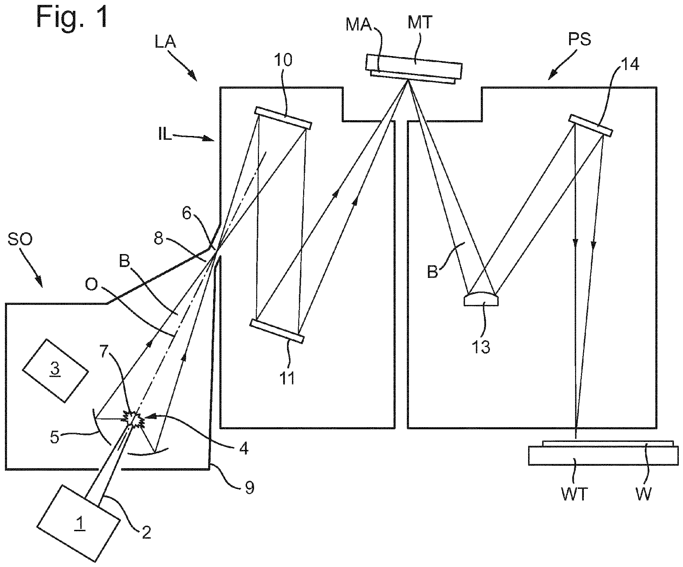

Figure 1 is a schematic illustration of a lithographic system. The lithographic system comprises a radiation source SO and a lithographic apparatus LA. The radiation source SO is configured to generate an extreme ultraviolet (EUV) radiation beam B. The lithographic apparatus LA comprises an illumination system IL, a support structure MT configured to support a patterning device MA, a projection system PS and a substrate table WT configured to support a substrate W. The illumination system IL is configured to condition the radiation beam B before it is incident upon the patterning device MA. The projection system is configured to project the radiation beam B (now patterned by the patterning device MA) onto the substrate W. The substrate W may include previously formed patterns. Where this is the case, the lithographic apparatus aligns the patterned radiation beam B with a pattern previously formed on the substrate W.

The radiation source SO, illumination system IL, and projection system PS may all be constructed and arranged such that they can be isolated from the external environment. A gas at a pressure below atmospheric pressure (e.g. hydrogen) may be provided in the radiation source SO. A vacuum may be provided in the illumination system IL and/or the projection system PS. A small amount of gas (e.g. hydrogen) at a pressure well below atmospheric pressure may be provided in the illumination system IL and/or the projection system PS.

The radiation source SO shown in Figure 1 is of a type that may be referred to as a laser produced plasma (LPP) source. A source laser 1, which may for example be a CO₂ laser, is arranged to deposit energy via a laser beam 2 into a fuel, such as tin (Sn) that is provided from a fuel emitter 3. Although tin is referred to in the following description, any suitable fuel may be used. The fuel may for example be in liquid form, and may for example be a metal or alloy. The fuel emitter 3 may comprise a nozzle configured to direct tin, for example, in the form of droplets, along a trajectory towards a plasma formation region 4. The laser beam 2 is incident upon the tin at the plasma formation region 4. The deposition of laser energy into the tin creates a plasma 7 at the plasma formation region 4. Radiation, including EUV radiation, is emitted from the plasma 7 during de-excitation and recombination of ions of the plasma.

The EUV radiation is collected and focused by a near normal incidence radiation collector 5 (sometimes referred to more generally as a normal incidence radiation collector). The collector 5 may have a multilayer structure that is arranged to reflect EUV radiation (e.g. EUV radiation having a desired wavelength such as 13.5 nm). The collector 5 may have an elliptical configuration, having two ellipse focal points. A first focal point may be at the plasma formation region 4, and a second focal point may be at an intermediate focus 6, as discussed below.

In other embodiments of a laser produced plasma (LPP) source the collector 5 may be a so-called grazing incidence collector that is configured to receive EUV radiation at grazing incidence angles and focus the EUV radiation at an intermediate focus. A grazing incidence collector may, for example, be a nested collector, comprising a plurality of grazing incidence reflectors. The grazing incidence reflectors may be disposed axially symmetrically around an optical axis O.

The radiation source SO may include one or more contamination traps (not shown). For example, a contamination trap may be located between the plasma formation region 4 and the radiation collector 5. The contamination trap may for example be a rotating foil trap, or may be any other suitable form of contamination trap.

The source laser 1 may be separated from the radiation source SO. Where this is the case, the laser beam 2 may be passed from the source laser 1 to the radiation source SO with the aid of a beam delivery system (not shown) comprising, for example, suitable directing mirrors and/or a beam expander, and/or other optics. The source laser 1 and the radiation source SO may together be considered to be a radiation system.

Radiation that is reflected by the collector 5 forms a radiation beam B. The radiation beam B is focused at point 6 to form an image of the plasma formation region 4, which acts as a virtual radiation source for the illumination system IL. The point 6 at which the radiation beam B is focused may be referred to as the intermediate focus. The radiation source SO is arranged such that the intermediate focus 6 is located at or near to an opening 8 in an enclosing structure 9 of the radiation source.

The radiation beam B passes from the radiation source SO into the illumination system IL, which is configured to condition the radiation beam. The illumination system IL may include a facetted field mirror device 10 and a facetted pupil mirror device 11. The faceted field mirror device 10 and faceted pupil mirror device 11 together provide the radiation beam B with a desired cross-sectional shape and a desired angular distribution. The radiation beam B passes from the illumination system IL and is incident upon the patterning device MA held by the support structure MT. The patterning device MA (which may for example be a mask) reflects and patterns the radiation beam B. The illumination system IL may include other mirrors or devices in addition to or instead of the faceted field mirror device 10 and faceted pupil mirror device 11.

Following reflection from the patterning device MA the patterned radiation beam B enters the projection system PS. The projection system comprises a plurality of mirrors 13, 14 that are configured to project the radiation beam B onto a substrate W held by the substrate table WT. The mirrors 13, 14 which form the projection system may be configured as reflective lens elements. The projection system PS may apply a reduction factor to the radiation beam, forming an image with features that are smaller than corresponding features on the patterning device MA. A reduction factor of 4 may for example be applied. Although the projection system PS has two mirrors 13, 14 in Figure 1, the projection system may include any number of mirrors (e.g. six mirrors).

The lithographic apparatus may, for example, be used in a scan mode, wherein the support structure (e.g. mask table) MT and the substrate table WT are scanned synchronously while a pattern imparted to the radiation beam is projected onto a substrate W (i.e. a dynamic exposure). The velocity and direction of the substrate table WT relative to the support structure (e.g. mask table) MT may be determined by the demagnification and image reversal characteristics of the projection system PS. The patterned radiation beam that is incident upon the substrate W may comprise a band of radiation. The band of radiation may be referred to as an exposure slit. During a scanning exposure, the movement of the substrate table WT and the support structure MT may be such that the exposure slit travels over an exposure field of the substrate W.

The radiation source SO and/or the lithographic apparatus that is shown in Figure 1 may include components that are not illustrated. For example, a spectral filter may be provided in the radiation source SO. The spectral filter may be substantially transmissive for EUV radiation but substantially blocking for other wavelengths of radiation such as infrared radiation.

In other embodiments of a lithographic system the radiation source SO may take other forms. For example, in alternative embodiments the radiation source SO may comprise one or more free electron lasers. The one or more free electron lasers may be configured to emit EUV radiation that may be provided to one or more lithographic apparatuses.

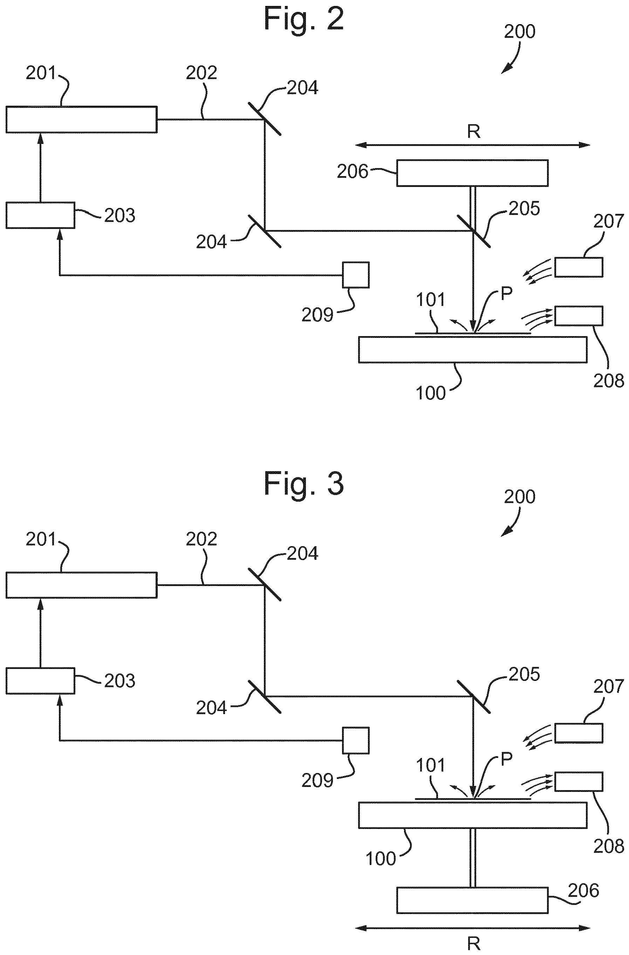

Figure 2 depicts a cleaning system 200 that is integrated into the lithographic apparatus LA. The cleaning system 200 is configured to clean a component 100 that is subject to contamination 101, e.g. deposits of carbon, during use of the lithographic apparatus. Component 100 may be a sensor, e.g. an optical sensor, whose output is affected by the presence of contamination on its outer surface.

Cleaning system 200 comprises a pulsed laser source 201 which emits pulses of radiation 202 and a beam delivery system 204, 205 to direct the pulses of radiation to a point of incidence P on the component 100. Pulsed laser source 201 desirably emits pulses having a duration of less than 1 ps (picosecond), desirably less than 500 fs (femtosecond). Beam delivery system 204, 205 is desirably configured to avoid lengthening the light pulses, e.g. by not having unnecessary mirrors and non-linear components.

The wavelength of the light emitted by the pulsed laser source is not particularly constrained; any convenient source emitting in the infra-red, visible and ultraviolet ranges may be used. In some cases it may be desirable to select a wavelength that is readily absorbed by the contaminant to be cleaned. Pulsed radiation with very short pulses may be regarded as relatively broadband, i.e. not consisting of a single wavelength. In such a case, the wavelength of the source should be considered to be the central wavelength of its emission spectrum.

The power of the laser source 201 is not particularly constrained. A higher power laser source allows for quicker cleaning but increases the risk of damage to the component to be cleaned if cleaning is carried out for too long. In experiments, a laser having a fluence in the range of 100 mJ/cm² to 500 mJ/cm² enabled cleaning more than 1000 times faster than a known method using a hydrogen radical generator.

Beam delivery system 204, 205 is depicted in Figure 2 as formed of folding mirrors but may alternatively or in addition comprise other optical components such as lenses (e.g. to focus the beam) and optical fibres. An actuator 206 is configured to move one of the optical components of the beam delivery system, e.g. mirror 205, in order to move the point of incidence P (which may also be referred to as the cleaning spot) on component 100. The range of movement R of actuator 206 is sufficient to encompass the part of component 100 that is to be cleaned. It will be appreciated that actuator 206 may rotate an optical component, rather than displace it, in order to move the point of incidence P.

Beam delivery system 204, 205 may comprise optical components to divide the output of pulsed source 201 onto multiple beams to create multiple cleaning spots. Conversely, beam delivery system 204, 205 may comprise optical components to combine the outputs of multiple laser sources to provide one higher powered beam.

By delivering pulses of radiation, an embodiment of the invention can remove the contamination without excessively heating, and thereby damaging, the component 100. The invention does not rely on a particular mechanism to drive off the contamination and may be referred to herein as ablation without implying any specific mechanism. In some cases, the laser irradiation may cause or promote a reaction between the contamination and a local environment to form a gaseous reaction product. In some cases thermal shock due to rapid localised heating causes particles of contamination to be thrown off the object 100. In other cases, the heat delivered by the pulses of radiation causes the contamination to sublimate or melt and evaporate. In other cases the pulses of radiation cause a contaminant compound to break up into it elemental components. Material driven off the component 100, by any mechanism, is referred to herein as the ejecta.

Through experimentation, it is possible to determine an amount or irradiation, e.g. expressed in pulses per unit area or total energy per unit area, that is sufficient to remove a known amount of contamination without damaging the component 100. An embodiment of the invention comprises a controller 203 configured to control the radiation source 201 and actuator 206 to irradiate the component 100 with a predetermined number of pulses per unit area.

The number of pulses per unit area to be delivered to the component 100 may be determined based on, for example, a measured degree of contamination of the component 100. The degree of contamination may be measured or predicted. For example, the rate of growth of contamination as a function of time or of exposures performed may be measured or estimated and the cleaning process may be controlled on the basis of a predicted amount of contamination calculated on the basis of an amount of time or number of exposures performed since the last cleaning process was performed. A dedicated sensor may be provided to measure contamination. If the object to be cleaned is a sensor then the amount of contamination may be estimated from the sensor response, e.g. to a known stimulus. This sensor response may for example be compared with a predetermined value, which predetermined value may for example be a fixed value or a value obtained from a previous known stimulus.

In an embodiment, cleaning can be performed in stages: a predetermined amount of cleaning is performed, the component is inspected to determine if contamination is sufficiently removed, and if not more cleaning is performed.

Alternatively or in addition, a chemical sensor 209 can be provided in the vicinity of the object to be cleaned and configured to detect substances driven off the object 100 by the cleaning process or reaction products thereof. Using such a chemical sensor, controller 203 controls the radiation source 201 and actuator 206 to continue cleaning until the chemical sensor 209 detects a reduction in substances, indicating that cleaning has removed all the contamination.

Having driven the contamination off the object 100 by the application of pulsed radiation, it is desirable to prevent that the ejecta driven off by the pulsed radiation re-attaches to the component 100 or any other place in the lithographic apparatus where it is undesirable. In an embodiment, the ejecta is simply pumped away. A flow of gas can be provided to assist removal of the ejecta. Two approaches can be taken, individually or in combination, to improve the removal of the ejecta.

Firstly, it is possible to react the ejecta with another substance to form a substance that will not re-adhere to the component and/or is easier to pump away. To this end, a reagent source 207 can be provided in the vicinity of the component 100 to provide a suitable reagent to react with the ejecta. In the case of carbonaceous contamination, the reagent may contain O or H to react with C in order to form gaseous CO₂ or CH₄.

Secondly, a getter device 208 can be provided to collect the ejecta. In an embodiment, the getter device comprises a collector surface to which the ejecta preferentially adheres, adsorbs or absorbs. In an embodiment, the getter system comprises a cooling system configured to cool the collector surface. It is known that many substances stick more readily to cold surfaces. The getter system may also comprise a heating system to drive the accumulated ejecta off the collector surface at a convenient time. In an embodiment the collector surface is made of a substance with which the ejecta readily reacts. In an embodiment, the collector surface is sufficient to accumulate ejecta throughout the life of the lithographic apparatus. The collector surface may be configured to be readily replaceable when necessary.

A second embodiment of the invention is depicted in Figure 3. The embodiment of Figure 3 is the same as the embodiment of Figure 2 except as described below. In particular, components of the embodiment of Figure 3 that are the same as components of the embodiment of Figure 2 are denoted with like references.

The embodiment of Figure 3 differs from that of Figure 2 in that the actuator 206 is configured to move the object 100 rather than to move a component of the beam delivery system. In an embodiment, the component to be cleaned is a part of or embedded in the substrate table or the support structure for the patterning device (e.g. the mask table). For example the component to be cleaned can be an optical sensor, such as an energy sensor or an interferometric sensor or an image sensor; or a target, such an alignment sensor target or a fiducial.

Where the component is part of, or embedded in, the substrate table WT or the support structure MT for the patterning device, positioning means that are used to position the substrate table WT or the support structure MT during exposures can be used as the actuator to move the component during cleaning. Such positioning means may be capable of positioning in at least three degrees of freedom and have already a wide range of movement sufficient to enable exposures to be carried out onto a substrate W when the lithographic apparatus is processing substrates. This range of movement also enables multiple components to be positioned for cleaning using one beam delivery system. In addition, large components - such as the whole surface of the substrate table, a substrate holder, or a mask clamp - can be cleaned using an embodiment of the invention.

Actuator 206 may be capable of displacing the cleaning spot P and/or component 100 in one, two or three degrees of freedom. A single degree of freedom may be sufficient when the area of the component to be cleaned is small. Two degrees of freedom allows a larger area to be cleaned. Three degrees of freedom allows relative movement in the direction of the beam, moving the cleaning spot into and out of focus so controlling the area being cleaned and/or the irradiance.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

The term "EUV radiation" may be considered to encompass electromagnetic radiation having a wavelength within the range of 4-20 nm, for example within the range of 13-14 nm. EUV radiation may have a wavelength of less than 10 nm, for example within the range of 4-10 nm such as 6.7 nm or 6.8 nm.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin film magnetic heads, etc.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Preceding and/or alternative and/or supplemental embodiments of this invention may be represented as elaborated in the following clauses:
1] A lithographic apparatus comprising: a component subject to contamination; and a cleaning system, the cleaning system comprising:
   - a laser radiation source configured to emit pulses of radiation;
   - a beam delivery system configured to direct the radiation to a point of incidence on the component; and
   - an actuator for controlling the position of the point of incidence with respect to the component.
2] A lithographic apparatus according to clause 1, wherein the actuator is configured to move an optical component of the beam delivery system to control the position of the point of incidence.
3] A lithographic apparatus according to clause 2, wherein the actuator is configured to rotate or displace a mirror forming part of the beam delivery system.
4] A lithographic apparatus according to any one of clauses 1 to 3, wherein the actuator is configured to move the component.
5] A lithographic apparatus according to any one of the preceding clauses, wherein the component is part of, or mounted on, a substrate table.
6] A lithographic apparatus according to clause 5, wherein the actuator is configured to displace the substrate table in at least three degrees of freedom and has a range of movement large enough to position a substrate in a projection beam.
7] A lithographic apparatus according to any one of the preceding clauses, wherein the component is part of, or mounted on, a support structure for a patterning device.
8] A lithographic apparatus according to clause 7, wherein the actuator is configured to displace the support structure in at least three degrees of freedom and has a range of movement large enough to position the patterning device in a projection beam.
9] A lithographic apparatus according to any one of the preceding clauses, wherein the component is a sensor.
10] A lithographic apparatus according to clause 9, wherein the cleaning system further comprises a controller configured to control the laser radiation source and the actuator based on an output of the sensor.
11] A lithographic apparatus according to any one of the preceding clauses, wherein the laser radiation source is configured to emit pulses of radiation having a duration less than 1 ps, desirably less than 500 fs.
12] A lithographic apparatus according to any one of the preceding clauses, wherein the cleaning system further comprises a reagent source configured to supply a gaseous reagent, e.g. comprising O and/or H, in the vicinity of the point of incidence.
13] A lithographic apparatus according to any one of the preceding clauses, wherein the cleaning system further comprises a getter device in the vicinity of the point of incidence.
14] A lithographic apparatus according to clause 13, wherein the getter device comprises a collector surface and a cooling system configured to cool the collector surface.
15] A lithographic apparatus according to clause 13 or 14, wherein the getter device comprises a getter surface configured to adsorb, absorb and/or react with substances emitted from the contamination.
16] A lithographic apparatus according to any one of the preceding clauses, wherein the cleaning system further comprises a controller configured to control the laser radiation source and the actuator so as to irradiate the surface with a predetermined number of radiation pulses per unit area.
17] A lithographic apparatus according to any one of the preceding clauses, wherein the cleaning system further comprises a contamination sensor configured to sense the contamination on the component and to output a sensor signal; and a controller configured to control the laser radiation source and the actuator in response to the sensor signal.
18] A lithographic apparatus according to any one of the preceding clauses, wherein the cleaning system further comprises a chemical sensor configured to sense substances emitted from the contamination and to output a sensor signal; and a controller configured to control the laser radiation source and the actuator in response to the sensor signal.
19] A method of cleaning a component in a lithographic apparatus, the method comprising:
   - directing pulsed laser radiation at a point of incidence on the component; and
   - moving the point of incidence with respect to the component.
20] A method according to clause 19, wherein moving comprises moving an optical component of beam delivery system to control the position of the point of incidence.
21] A method according to clause 19 or 20, wherein moving comprises moving the component.
22] A method according to close 21, wherein the position of the point of incidence is kept stationary whilst moving the component.
23] A method according to any one of clauses 19 to 22, wherein the component is part of, or mounted on, a substrate table.
24] A method according to clause 23, wherein moving comprises moving the component using an actuator that is configured to displace the substrate table in at least three degrees of freedom and has a range of movement large enough to position a substrate in a projection beam.
25] A method according to any one of clauses 19 to 24, wherein the component is part of, or mounted on, a support structure for a patterning device.
26] A method according to clause 25, wherein moving comprises moving the component using an actuator that is configured to displace the support structure in at least three degrees of freedom and has a range of movement large enough to position the patterning device in a projection beam.
27] A method according to any one of clauses 19 to 26, wherein the component is a sensor.
28] A method according to clause 27, further comprising controlling the directing and moving based on an output of the sensor.
29] A method according to any one of clauses 19 to 28, wherein the pulsed laser radiation comprises pulses of radiation having a duration less than 1 ps, desirably less than 500 fs.
30] A method according to any one of clauses 19 to 29, further comprising supplying a gaseous reagent, e.g. comprising O and/or H, that reacts with substances emitted from the contamination.
31] A method according to any one of clauses 19 to 30, further comprising providing a getter device in the vicinity of the point of incidence.
32] A method according to clause 31, wherein the getter device comprises a collector surface and the method further comprises cooling the collector surface.
33] A method according to clause 31 or 32, wherein the getter device comprises a getter surface configured to adsorb, absorb and/or react with substances emitted from the contamination.
34] A method according to any one of clauses 19 to 33, further comprising controlling the directing and moving so as to irradiate a surface of the component with a predetermined number of radiation pulses per unit area.
35] A method according to any one of clauses 19 to 34, further comprising sensing the contamination on the component; and controlling the directing and moving in response to the sensing.
36] A method according to any one of clauses 19 to 35, further comprising sensing substances emitted from the contamination and to output a sensor signal; and controlling the directing and moving in response to the sensing.

## Claims

1. A lithographic apparatus comprising: a component subject to contamination; and a cleaning system, the cleaning system comprising:
a laser radiation source configured to emit pulses of radiation;
a beam delivery system configured to direct the radiation to a point of incidence on the component; and
an actuator for controlling the position of the point of incidence with respect to the component.

2. An apparatus according to claim 1,
wherein the actuator is configured to move:
an optical component of the beam delivery system to control the position of the point of incidence;
and/or
the component.

3. An apparatus according to any one of the preceding claims,
wherein the component is part of, or mounted on, a substrate table and/or a support structure for a patterning device.

4. An apparatus according to claim 3,
wherein the actuator is configured to displace the substrate table and/or the support structure for a patterning device, respectively, in at least three degrees of freedom and has a range of movement large enough to position a substrate in a projection beam.

5. An apparatus according to any one of the preceding claims,
wherein the component is a sensor, and
wherein the cleaning system optionally may further comprise a controller configured to control the laser radiation source and the actuator based on an output of the sensor.

6. An apparatus according to any one of the preceding claims,
wherein the laser radiation source is configured to emit pulses of radiation having a duration less than 1 ps, desirably less than 500 fs.

7. An apparatus according to any one of the preceding claims,
wherein the cleaning system further comprises a getter device in the vicinity of the point of incidence, and
wherein the getter device may optionally comprise:
a collector surface and a cooling system configured to cool the collector surface;
and/or
a getter surface configured to adsorb, absorb and/or react with substances emitted from the contamination.

8. An apparatus according to any one of the preceding claims,
wherein the cleaning system further comprises:
a reagent source configured to supply a gaseous reagent, e.g. comprising O and/or H, in the vicinity of the point of incidence;
and/or
a controller configured to control the laser radiation source and the actuator so as to irradiate the surface with a predetermined number of radiation pulses per unit area;
and/or
a contamination sensor configured to sense the contamination on the component and to output a sensor signal; and a controller configured to control the laser radiation source and the actuator in response to the sensor signal;
and/or
a chemical sensor configured to sense substances emitted from the contamination and to output a sensor signal; and a controller configured to control the laser radiation source and the actuator in response to the sensor signal.

9. A method of cleaning a component in a lithographic apparatus, the method comprising:
directing pulsed laser radiation at a point of incidence on the component; and
moving the point of incidence with respect to the component.

10. A method according to claim 9,
wherein moving comprises:
moving an optical component of beam delivery system to control the position of the point of incidence;
and/or
moving the component whilst the position of the point of incidence may optionally be kept stationary.

11. A method according to any one of claims 9 to 10,
wherein the component is part of, or mounted on, a substrate table and/or a support structure for a patterning device.

12. A method according to claim 11,
wherein moving comprises moving the component using an actuator that is configured to displace the substrate table and/or the support structure for a patterning device, respectively, in at least three degrees of freedom and has a range of movement large enough to position a substrate in a projection beam.

13. A method according to any one of claims 9 to 12,
wherein the component is a sensor.

14. A method according to claim 13, further comprising controlling the directing and moving based on an output of the sensor.

15. A method according to any one of claims 9 to 14,
wherein the pulsed laser radiation comprises pulses of radiation having a duration less than 1 ps, desirably less than 500 fs.

16. A method according to any one of claims 9 to 15, further comprising providing a getter device in the vicinity of the point of incidence, which getter device may optionally comprise:
a collector surface and the method further comprises cooling the collector surface;
and/or
a getter surface configured to adsorb, absorb and/or react with substances emitted from the contamination.

17. A method according to any one of claims 9 to 16, further comprising:
supplying a gaseous reagent, e.g. comprising O and/or H, that reacts with substances emitted from the contamination;
and/or
controlling the directing and moving so as to irradiate a surface of the component with a predetermined number of radiation pulses per unit area;
and/or
sensing the contamination on the component; and controlling the directing and moving in response to the sensing.
and/or
sensing substances emitted from the contamination and to output a sensor signal; and
controlling the directing and moving in response to the sensing.
